# EUROPEAN PATENT APPLICATION

(11) **EP 4 386 478 A1**
(43) Date of publication of application: **19.06.2024**
(21) Application number: 22212752.4
(22) Date of filing: 12.12.2022
(51) Int. Cl.: G03F 7/00, H01L 21/683

(54) **APPARATUS AND METHOD FOR ELECTROSTATICALLY CLAMPING A SUBSTRATE**

(71) Applicant: ASML Netherlands B.V., 5500 AH Veldhoven (NL)
(72) Inventor: JANSEN, Maarten, Mathijs, Marinus, 5500 AH Veldhoven (NL); VAN EMPEL, Tjarko, Adriaan, Rudolf, 5500 AH Veldhoven (NL); REIJNEN, Martinus, Cornelis, 5500 AH Veldhoven (NL); DE VRIES, Sjoerd, Frans, 5500 AH Veldhoven (NL)
(74) Representative: ASML Netherlands B.V.

(57) **Abstract**

The disclosure provides an apparatus comprising: at least one substrate table for holding a substrate, the substrate table being provided with an electrostatic clamp for electrostatically clamping the substrate; and at least one reflective surface for reflecting charged particles in a direction away from a front side of the substrate. A method of use comprises the steps of electrostatically clamping at least one substrate table on a substrate table; releasing the clamped substrate; lifting the substrate from the substrate table; and providing at least one reflective surface for reflecting charged particles in a direction away from a front side of the substrate.

## Description

### FIELD

The present invention relates to an apparatus and method comprising an electrostatic clamp for clamping a substrate. Such clamp can be used, for instance, to hold substrates in deep vacuum environments. Electrostatic clamping can be used to hold a wafer positioned on a wafer stage of a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

In EUV, the wafer is typically clamped electrostatically on the wafer stage chucks, for instance during measurement and expose sequences. To get good imaging overlay, the electrostatic clamping voltage may be very high, in the order of 3.2 kV. Another way to describe the electrostatic clamp is a pressure iso force. In an EUV lithography apparatus, the pressure iso force may exceed 50 kPa. In the future, the clamping voltage or the pressure iso force may increase further.

The high electrostatic field due to the clamp voltage leads to electric charging of the clamp and of the wafer surface, and also of any particles on top of these surfaces. These charged particles can get released when releasing the clamp voltage to remove the wafer after exposure, and reach the wafer front side (FS). Charged particles hitting the front side of the exposed wafer may deposit on the front side and lead to yield-loss of the final lithographic product on the wafer (such as a number of microchips). Herein, please note that the charged particles may have a size in the order of 0.1 to 5 µm.

The result is that wafer backside damage (wafer particles) and wafer backside contamination (contamination from outside scanner sources) have an additional transport mechanism to reach the front or top of the wafer when unloading the wafer from the wafer stage. When the wafer is lifted from the electrostatic clamp, the particles that already have a charge (on the wafer backside or on the wafer stage clamp) can get released. The released particles will have high velocities and start bouncing through the scanner with a fraction of the particles ending up on the wafer front side. There, they can be harmful to the lithographic product and negatively impact the specifications thereof.

The present disclosure aims to obviate or at least limit the impact of charged particles on the lithographic product.

### SUMMARY

The disclosure provides an apparatus comprising:
at least one substrate table for holding a substrate, the substrate table being provided with an electrostatic clamp for electrostatically clamping the substrate; and
at least one reflective surface for reflecting charged particles in a direction away from a front side of the substrate.

In an embodiment, the apparatus comprises: a heat shield arranged above the at least one substrate table, wherein a first reflective surface of the at least one reflective surfaces is arranged on the heat shield on a side thereof facing the at least one substrate table.

In an embodiment, the first reflective surface has a shape substantially corresponding to a circumference of the substrate.

In an embodiment, the first reflective surface is ring shaped, having a slanted surface allowing particles to reflect sideways away from the substrate.

In an embodiment, the at least one substrate table comprises one or more hardware elements, each side of a hardware element facing the substrate being provided with a second reflective surface of the at least one reflective surface.

In an embodiment, the second reflective surface is slanted in upward direction, allowing particles to reflect in upward direction away from the substrate table.

In an embodiment, apparatus of any of the previous claims, the at least one substrate table comprises a ring surrounding the substrate, the ring being provided with a third reflective surface of the at least one reflective surface facing the circumference of the substrate.

In an embodiment, the third reflective surface is slanted or curved in a downward direction, allowing particles to reflect in a downward direction towards the substrate table and/or a backside of the substrate.

In an embodiment, the ring is comprised of a number of separate block shaped elements.

In an embodiment, the ring is arranged to engage with the circumference of the substrate, allowing to position the substrate on the substrate table.

In an embodiment, the at least one reflective surface has a surface roughness not exceeding 0.8 Ra.

In an embodiment, the at least one reflective surface has a surface roughness in the order of 0.4 to 0.05 Ra or lower.

According to another aspect, the disclosure provides a wafer stage comprising the apparatus of any of claims 1 to 12.

According to another aspect, the disclosure provides a lithographic system comprising the apparatus of any of claims 1 to 12.

According to another aspect, the disclosure provides a method comprising the use of the apparatus of any of claims 1 to 12.

The method may comprise the steps of:
electrostatically clamping at least one substrate table on a substrate table;
releasing the clamped substrate;
lifting the substrate from the substrate table; and
providing at least one reflective surface for reflecting charged particles in a direction away from a front side of the substrate.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2A depicts a side view of a wafer stage, indicating a state of the art system;
- Figures 2B and 2C depict a side view of a wafer stage showing embodiments of the disclosure including a reflective surface;
- Figure 3 depicts a perspective view of the reflective surface of Fig. 2;
- Figure 4 depicts a plan view of the reflective surface of Fig. 2;
- Figure 5 a perspective view of a substrate table including examples of hardware near the substrate table;
- Figure 6A depicts a side view of the wafer stage, indicating a state of the art system;
- Figures 6B and 6C depict a side view of the wafer stage showing embodiments of the disclosure including two reflective surfaces;
- Figure 7 depicts a perspective view of a substrate table including embodiments of a reflective surface arranged around the circumference of the substrate on the substrate table;
- Figure 8 depicts a side view of a detail a substrate table, indicating a substrate on an electrostatic clamp and a conventional substrate positioner;
- Figure 9 depicts a side view of a detail a substrate table, indicating a substrate on an electrostatic clamp and a substrate positioner provided with a reflective surface according to the disclosure;
- Figure 10 depicts a side view of a detail a substrate table, indicating a substrate on an electrostatic clamp and a substrate positioner provided with another embodiment of a reflective surface according to the disclosure; and
- Figure 11 depicts a side view of a wafer stage, including an embodiment of the disclosure including three reflective surfaces.

### DETAILED DESCRIPTION

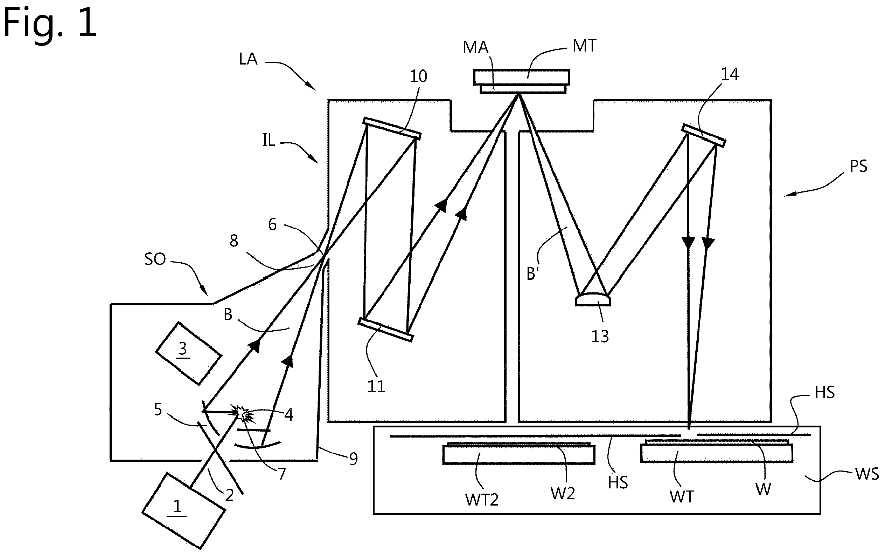

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

The section of the lithographic apparatus comprising the wafer table may be referred to as the wafer stage WS. The wafer stage is depicted schematically in Figure 1. The wafer stage may be a separate container. The wafer stage may for instance be filled with a small amount of a gas having a predetermined composition. For EUV lithography, a small amount of gas herein typically still relates to a low vacuum environment. For instance, hydrogen may be used as a buffer gas in the wafer stage WS, at a pressure of about 100 Pa. During exposure of the substrate W, the hydrogen may flow over and along the substate at a rate in the order of a one or more standard liters per minute (slm).

The wafer stage may comprise more than one wafer table. For instance, the wafer stage may comprise a second substrate table WT2, for holding a second substrate W2. Each substrate table may be movable, allowing the respective substrate tables to change position. Referring to Fig. 1, for instance, one substrate table WT may be in an expose position, allowing the respective substrate to be exposed to the radiation B'. Another substrate table WT2 may be in a measurement position, also referred to as load/unload position. The measurement position of the wafer stage is typically provided with one or more sensors to measure relevant characteristics of the respective substrate, for instance before commencing exposure. Said characteristics may include, but are not limited to, a position on the substrate table, a surface height map (surface flatness), rotation, etc.

A substrate handler is typically arranged at or near the measurement location, allowing the substrate W2 to be removed from the wafer stage and a new substrate to be loaded into the wafer stage and onto the respective substrate table. For an example and more detail of a wafer stage comprising multiple substrate tables and one or more robot handlers, see for instance patent document US-11,105,619.

The wafer stage WS may comprise a heat shield HS, for shielding the respective substrates from heat in other parts of the lithographic apparatus. The heat shield may be arranged above the expose location and/or above the load/unload location. The heat shield may extend along the entire wafer stage, covering both the expose location and the loading location.

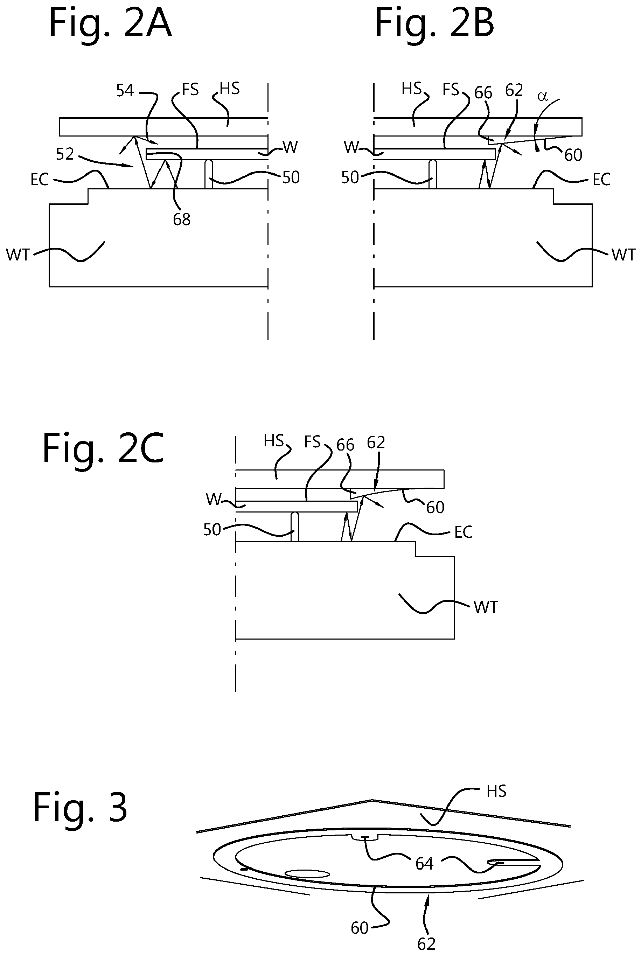

Generally referring to Fig. 2, each substrate table may typically be provided with an electrostatic clamp EC for holding the substrate. The clamp may also be referred to as a chuck. For examples or details of an electrostatic clamp EC and the functioning thereof, reference is made to, for instance, US-7,940,511 and US-2013/0,301,028. The present disclosure relates to technology to manage electrostatic particles emitted from a substrate upon release thereof from the electrostatic clamp.

For instance in an EUV lithography machine, but potentially also for other applications, the substrate is clamped electrostatically on the electrostatic clamp EC of the wafer stage chucks. The substrate is clamped in position during, for instance, measurement and expose sequences. In recent years, the clamping voltage as applied as increased. To get good imaging and overlay, the electrostatic clamping voltage, for instance, may be as high as 3.2 kV. In the future this clamping voltage might even increase further. The high clamp voltage may result in electric charging of the clamp EC, of a lower surface, referred to as backside, of the substrate, and of any particles that may have deposited on or released from these surfaces. The substrate may be lifted, for instance, by a number of retractable lifting pins 50. The pins 50 lift the substrate, allowing a handler tool to slide under the substrate, and remove the substrate from the clamp. Positioning a substrate works in opposite order, i.e. a handler tool positions the substrate on the pins 50, the handler tool is remove, the pins 50 are retracted or lowered, so that the substrate W will be positioned on the electrostatic clamp EC.

Referring to Figure 2A, upon release of the clamping voltage and lift of the substrate to remove the substrate from the clamp, the charged particles 52 may release from the surface of the clamp or the substrate.

The released particles may reflect on surfaces. If the reflection is diffuse, due to surface roughness, at least some of the charged particles 54 may reflect in the direction of the front side FS of the substrate W. At the front side of the substrate, the particles may deposit on the front side of the substrate. As the particles may have a diameter in the range of 0.1 |im up to several µm, the particles have a size sufficient to interfere with printed patterns or other structures, potentially resulting in reduced yield or loss of printed structures. Thus, the electrostatic charge and the release thereof provides a potential transport mechanism for wafer backside damage (typically resulting in particles of the same material as the wafer) and wafer backside contamination (typically contamination from outside scanner sources) to reach the top of the substrate at unloading of the substrate. When the wafer W is lifted from the clamp EC, the particles 52 that already have a charge (on wafer backside or electrostatic clamp) can get released. The released particles will have high velocities and start bouncing through the scanner, with a fraction of the particles ending up on the wafer front side where they can be harmful for processes.

Embodiments of the present disclosure implement several design changes to the wafer stage. Generally referring to Figure 2B, in an embodiment, the heat shield HS which is typically arranged above the substrate table, may be provided with a first reflective surface 60, for directing charged particles away from the front side FS of the substrate. The first reflective surface 60 may be arranged on a chamfered ring 62. The first reflective surface may have been polished to reduce the surface roughness thereof below a predetermined threshold value. The ring 62 may be attached to the heat shield HS, at a location which is above the wafer W when the respective substrate table is at the unload position. The ring may be connected to the heat shield using connectors 64. The connectors 64 may include, but are not limited to welded connection, bolts, screws, rivets, etc.

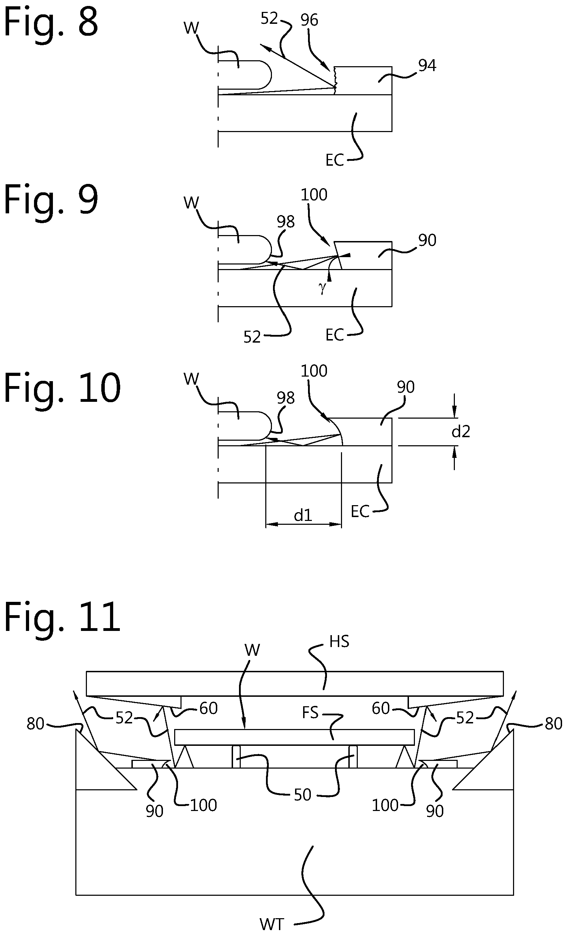

The ring 62 may have an inner circumference 66 substantially matching to the outer circumference 68 of the substrate W. Substantially matching herein may indicate that both circumferences are substantially similar. Substantially similar herein may include, for instance, within a range of +/- 50%, for instance +/- 20%. The ring 62 may have an outer circumference in the range of the substrate diameter plus 5% to 80%. The ring surface 60 may be substantially circular. Alternatively, the ring surface 60 may deviate from a circular shape. The first reflective surface 60 may have a curvature, as exemplified in Figure 10. The slope of the first reflective surface 60 may be in the range of 5 to 20 degrees. The latter means that the angle α at the outer circumference of the ring is in the range of 5 to 20 degrees.

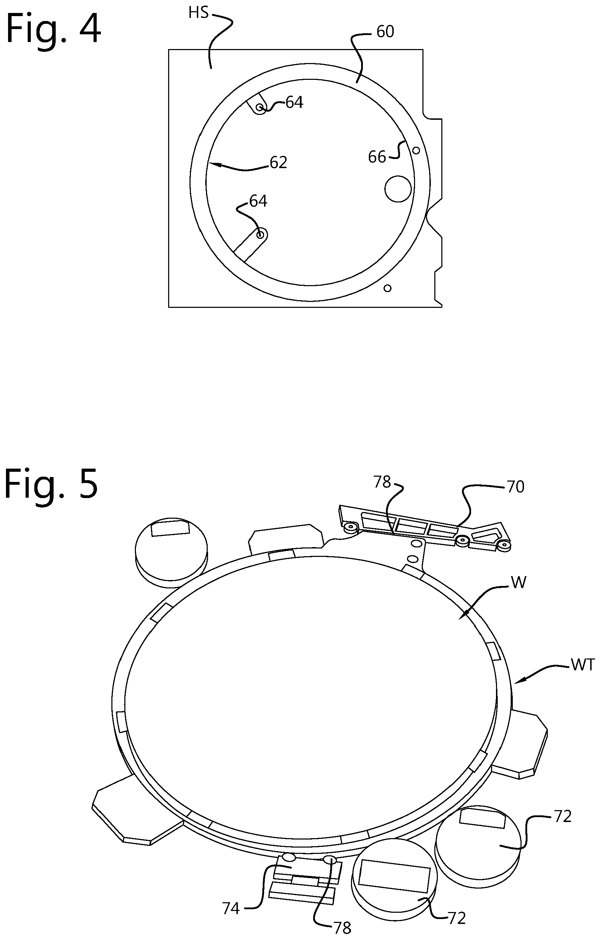

Generally referring to Figure 5, the wafer stage WS may comprise one or more hardware elements 70, 72, 74 arranged in the vicinity of the wafer table WT. Hardware elements herein may include, but is not limited to, sensors, robot gripper aligners, electrical cabling, connectors, etc. Hardware elements may, for instance, be arranged on the substrate table WT. Hardware elements may, for instance, be arranged at various locations around the circumference of the substrate W. If so, the hardware elements may have a surface 78 facing the side or circumference of the substrate W.

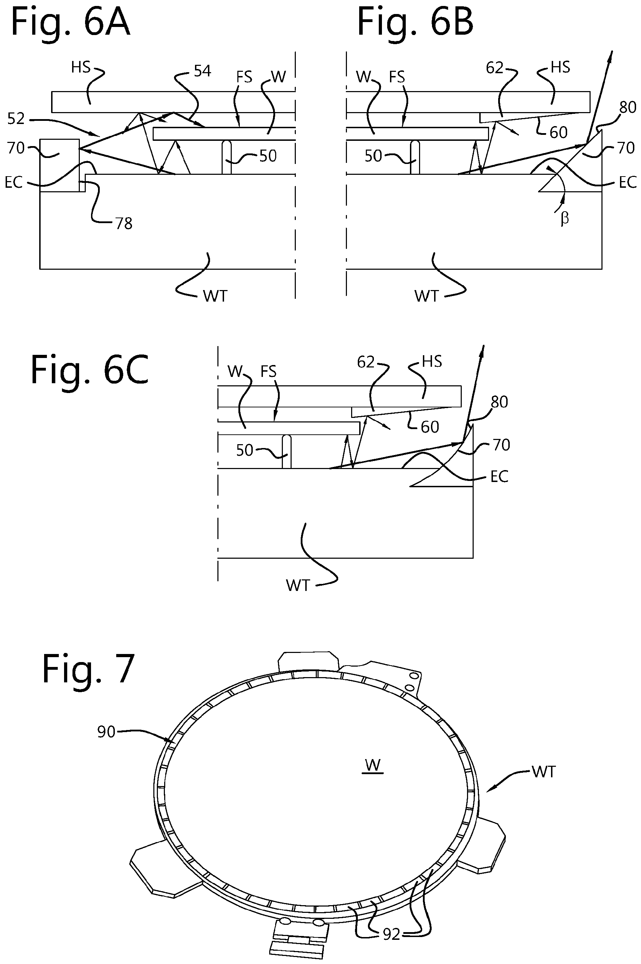

Referring to Figure 6A, upon unloading the substrate, including the step of releasing the clamping voltage and lift of the substrate W to remove the substrate from the electrostatic clamp EC, charged particles 52 may release from the surface of the clamp EC or from a lower surface of the substrate.

The released particles may reflect on surfaces. Hardware items 70 (or 72, 74) positioned next to the substrate W may have one or more side surfaces 78 facing the substrate W. If reflection of particles 52 on the side surface 78 is diffuse, due to surface roughness, at least some of the charged particles 54 may reflect in the direction of the front side FS of the substrate W. The particles 54 may reflect via more than one surface, as exemplified in Figure 6A. At the front side of the substrate, the particles may deposit on the front side of the substrate.

Generally referring to Figure 6B, a side of a hardware element 70 (or 72, 74) facing the substrate W may be provided with a second reflective surface 80 for directing the particles 52 in a direction away from the front side of the substrate. Herein, figure 6B only shows hardware item 70 as an example, but the reflective surface 80 may be applied to any hardware item 70, 72, 74 as exemplified in Figure 5. The reflective surface 80 may be polished to limit the surface roughness thereof to below a preset threshold, to limit diffuse reflection. Optionally, the second reflective surface may have a curvature in cross section (similar to the curvature of as shown in Figure 6B),

In a practical embodiment, the second reflective surface may be arranged under an angle β with respect to horizontal. Said angle β may be in the range of about 5 to 60 degrees, for instance about 30 to 50 degrees, for instance about 45 degrees. Herein, the second reflective surface 80 may be slanted in upward direction, allowing the particles 52 to reflect in upward direction with respect to the electrostatic clamp EC and away from the substrate table.

In an embodiment, the at least one substrate table WT may be provided with a ring 90 surrounding the substrate W. The ring 90 may be comprised of a number of separate blocks 92. The ring 90 functions as a positioning device for positioning the substrate with respect to the substrate table WT. Collectively, the blocks 92 create the ring 90. Herein, the blocks 92 may cover at least 90% or more, for instance at least 95%, for instance at least 98%, of the circumference of the substrate W. The ring 90 may be adapted to engage with the circumference 98 of the substrate, allowing to position the substrate on the substrate table.

Figure 8 indicates an example of a prior art substrate table, which may be provided with a limited number, for instance three or four, blocks to position the substrate. Said blocks may be referred to as wafer catchers. In practice, the wafer catchers may have a surface 96 facing the substrate which is relatively rough. As a result, particles 52 may reflect on said surface 96 in a diffuse manner, resulting in some of said particles 54 reaching the front side of the substrate. Relatively rough herein may indicate a surface resulting in diffuse reflection. Relatively rough may indicate a surface roughness between Ra = 1.2 and 3.2 µm or more. Ra < 1.2 µm may be defined as a surface having a relatively easy to achieve finish, with medium surface roughness. Surfaces having Ra < 0.8 µm may be defined as a surface having a fairly fine finish, relatively smooth.

According to the disclosure, an inner surface 100 of the ring 90 may be provided with a third reflective surface 100 for reflecting particles away from the front side of the substrate W.

As exemplified in Figures 9 and 10 respectively, the third reflective surface 100 may be slanted or curved in a downward direction. The latter allows particles 52 to reflect in a downward direction, for instance towards the substrate table WT and/or towards the electrostatic clamp EC. For instance, the surface 100 may be arranged at an angle γ with respect to the horizontal. Herein, the angle γ may be in the range of about 45 to 85 degrees, for instance about 70 to 80 degrees. Curvature of the surface 100, as indicated in Figure 10, may have a radius in the order of 1 to 5 cm. A horizontal distance d1 between the circumference of the substrate and the reflective surface 100 is, in a practical embodiment, as small as possible. Small herein may be in the order of 0.1 to 1 mm. The ring 90, and any blocks 92 comprised in said ring 90, may have a height d2 generally in the order of the height or thickness of the substrate W. Said height may be, for instance, in the range of about 0.5 to 1 mm.

Generally referring to Figure 11, in an embodiment, a wafer stage WS according to the disclosure may comprise a number of reflective surfaces, to direct particles 52 away from the substrate. In particular, said reflective surfaces reflect particles away from the front side of the substrate. The wafer stage may comprise a first reflective surface 60, a second reflective surface 80, and/or a third reflective surface 100.

In a practical embodiment, the respective reflective surfaces of the disclosure prevent diffusive reflection. Said surfaces may have a surface roughness not exceeding 0.4 Ra (µm). In an embodiment, the surface roughness may be 0.05 Ra at most. Herein, Ra is the average roughness of a surface. Rz is the difference between the tallest "peak" and the deepest "valley" in the surface. Ra is the average difference between all peaks and valleys of a surface.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An apparatus comprising:
at least one substrate table for holding a substrate, the substrate table being provided with an electrostatic clamp for electrostatically clamping the substrate; and
at least one reflective surface for reflecting charged particles in a direction away from a front side of the substrate.

2. The apparatus of claim 1, comprising:
a heat shield arranged above the at least one substrate table,
wherein a first reflective surface of the at least one reflective surfaces is arranged on the heat shield on a side thereof facing the at least one substrate table.

3. The apparatus of claim 2, the first reflective surface having a shape substantially corresponding to a circumference of the substrate.

4. The apparatus of claim 2 or 3, the first reflective surface being ring shaped, having a slanted surface allowing particles to reflect sideways away from the substrate.

5. The apparatus of any of the previous claims, the at least one substrate table comprising one or more hardware elements, each side of a hardware element facing the substrate being provided with a second reflective surface of the at least one reflective surface.

6. The apparatus of claim 5, the second reflective surface being slanted in upward direction, allowing particles to reflect in upward direction away from the substrate table.

7. The apparatus of any of the previous claims, the at least one substrate table comprises a ring surrounding the substrate, the ring being provided with a third reflective surface of the at least one reflective surface facing the circumference of the substrate.

8. The apparatus of claim 7, the third reflective surface being slanted or curved in a downward direction, allowing particles to reflect in a downward direction towards the substrate table and/or a backside of the substrate.

9. The apparatus of claim 7 or 8, the ring being comprised of a number of separate block shaped elements.

10. The apparatus of claim 7, 8 or 9, the ring being arranged to engage with the circumference of the substrate, allowing to position the substrate on the substrate table.

11. The apparatus of any of the previous claims, the at least one reflective surface having a surface roughness not exceeding 0.8 Ra.

12. The apparatus of any of the previous claims, the at least one reflective surface having a surface roughness in the order of 0.4 to 0.05 Ra or lower.

13. Wafer stage comprising the apparatus of any of claims 1 to 12.

14. A lithographic system comprising the apparatus of any of claims 1 to 12.
